# EUROPÄISCHE PATENTANMELDUNG

(11) **EP 3 913 110 A1**
(43) Veröffentlichungstag der Anmeldung: **24.11.2021**
(21) Anmeldenummer: 20175708.5
(22) Anmeldetag: 20.05.2020
(51) Int. Cl.: C23C 28/00, C23C 16/40, C23C 16/455, C23C 16/50, B01L 3/02

(54) **LABORVERBRAUCHSARTIKEL UND VERFAHREN ZUR HERSTELLUNG EINES SOLCHEN LABORVERBRAUCHSARTIKELS**

(71) Anmelder: Eppendorf AG, 22339 Hamburg (DE)
(72) Erfinder: Taesler, Christian, 21614 Buxtehude (DE); Günther, Christopher, 22085 Hamburg (DE)
(74) Vertreter: Hauck Patentanwaltspartnerschaft mbB

(57) **Zusammenfassung**

Die Erfindung betrifft einen Laborverbrauchsartikel (10) mit einem Grundkörper (20) aus einem Polymermaterial und einer zumindest abschnittsweise auf den Grundkörper (20) aufgebrachten flüssigkeitsabweisenden Beschichtung (26). Es ist vorgesehen, dass zwischen dem Grundkörper (20) und der flüssigkeitsabweisenden Beschichtung (26) eine Barriereschicht (28) ausgebildet ist, welche ein Herauslösen und/oder Freisetzen von in dem Grundkörper (20) enthaltenen Kontaminationen oder eine Diffusion der im Grundkörper (20) enthaltenen Kontaminationen in die flüssigkeitsabweisende Beschichtung (26) verhindert.

Die Erfindung betrifft ferner ein Verfahren zur Herstellung eines solchen Laborverbrauchsartikels (10).

## Beschreibung

Die Erfindung betrifft einen Laborverbrauchsartikel, insbesondere einen Einwegartikel, sowie ein Verfahren zur Herstellung eines solchen Laborverbrauchsartikels gemäß dem Oberbegriff der unabhängigen Patentansprüche.

Laborgeräte und insbesondere Laborverbrauchsmaterialien sollten möglichst flüssigkeitsabweisend sein, um zu vermeiden, dass Reagenzien oder Proben auf den Oberflächen dieser Laborgeräte oder Laborverbrauchsmaterialien verbleiben. Insbesondere bei biochemischen und chemischen Reaktionen, die beispielsweise zu Forschungs- oder Analysezwecken und insbesondere in der medizinischen oder forensischen Diagnostik durchgeführt werden, werden häufig sehr kleine Mengen an Proben oder Reagenzien verwendet. Das Anhaften von Proben oder Reagenzien auf der Oberfläche von Laborgeräten, die während der Proben- oder Reagenzienhandhabung in direkten Kontakt mit diesen Proben oder Reagenzien kommen, kann die Ergebnisse erheblich beeinflussen. Da viele der Reagenzien extrem kostspielig sind, ergeben sich aus dem Reagenzienverlust auf diese Weise auch negative wirtschaftliche Auswirkungen.

Plasmaabscheidungstechniken sind für die Abscheidung von Polymerbeschichtungen auf einer Reihe von Oberflächen und insbesondere auf Gewebeoberflächen ziemlich weit verbreitet. Diese Technik wird als saubere, trockene Technik anerkannt, die im Vergleich zu herkömmlichen nasschemischen Verfahren wenig Abfall erzeugt. Mit dieser Methode werden Plasmen aus organischen Molekülen erzeugt, die einem elektrischen Feld ausgesetzt sind. Wenn dies in Gegenwart eines Substrats erfolgt, polymerisieren die Radikale der Verbindung im Plasma auf dem Substrat. Herkömmliche Polymersynthese neigt dazu, Strukturen zu erzeugen, die Wiederholungseinheiten enthalten, die der Monomerspezies stark ähneln, während ein unter Verwendung eines Plasmas erzeugtes Polymernetzwerk äußerst komplex sein kann. Die Eigenschaften der resultierenden Beschichtung können von der Art des Substrats sowie von der Art des verwendeten Monomers und den Bedingungen, unter denen es abgeschieden wird, abhängen. Durch die Verwendung eines bestimmten Monomertyps unter bestimmten Abscheidungsbedingungen können Laborverbrauchsmaterialien mit ultra-nichtbindenden Nanobeschichtungen hergestellt werden.

Die DE 20 2004 012 943 U1 offenbart einen Laboreinmalartikel aus Kunststoff für die Behandlung und Aufarbeitung von flüssigen Proben, die Nukleinsäure enthalten, bei dem mindestens ein die flüssige Probe kontaktierender Wandbereich aus mit mindestens einem Additiv versetztem Polypropylen besteht, wobei das Additiv die Bindungsfähigkeit des Polypropylens für Nukleinsäure herabsetzt. Dadurch lässt sich ein transparenter Laboreinmalartikel herstellen, welcher sich auf eine besonders einfache Art und Weise herstellen lässt und insbesondere im kritischen Hochsalzbereich gegenüber herkömmlichen Laboreinmalartikeln eine deutlich reduzierte Bindungsaffinität zu Nukleinsäuren aufweist.

Die US 6 551 950 B1 offenbart eine öl- und wasserabweisende Beschichtung für Textilien, bei der ein Fluorpolymer auf die Textilien aufgebracht wird. Das Textil bleibt atmungsaktiv und luftdurchlässig, da durch die Behandlung die Fasern mit einem sehr dünnen, flüssigkeitsabweisenden Film überzogen werden. Um diese Ausrüstungen dauerhaft zu machen, werden sie mitunter gemeinsam mit vernetzenden Harzen aufgebracht, welche die Fluorpolymerbehandlung mit den Fasern verbinden. Während sich auf diese Art und Weise eine gute Beständigkeit gegen Waschen und chemische Reinigung erreichen lässt, können die vernetzenden Harze die Zellulosefasern ernsthaft schädigen und die mechanische Festigkeit des Materials verringern.

Aus der EP 2 532 716 A1 ist eine proteinabweisende Beschichtung auf einer Substratoberfläche eines Laborartikels bekannt. Lipidabweisende Beschichtungen sind beispielsweise in der Kosmetikindustrie von Interesse, um ein unerwünschtes Anhaften von hydrophilen Einheiten organischer Moleküle kosmetischer Formulierungen zu vermeiden, die in Behältern mit Oberflächen mit einer Affinität zu solchen hydrophoben Einheiten, z.B. Behälter auf Basis von Polyolefinmaterialien. Darüber hinaus können lipidabweisende Beschichtungen dazu dienen, die Migration von Inhaltsstoffen kosmetischer Formulierungen in das Verpackungsmaterial zu vermeiden oder zu verringern, was die mechanischen Eigenschaften des Verpackungsmaterials negativ beeinflussen kann.

Für Biokonsumgüter ist die Vorbereitung und Lagerung biologischer Proben die Grundlage für erfolgreiche Experimente und insbesondere quantitative Analysen. Bei Arbeiten mit geringen Volumina oder Konzentrationen sind die Reinheit der Probe und die Gewinnung nach der Herstellung von entscheidender Bedeutung. In diesen Fällen sind Verluste kritisch, da sie zu falschen oder unzuverlässigen Analyseergebnissen führen können. Um dies zu vermeiden, wird in der EP 2 532 716 A1 vorgeschlagen, auf das Grundmaterial des Substrates ein Polymerisationsprodukt eines in der EP2 532 716 A1 beschriebenen Monomers aufzubringen.

Aus der EP 3 333 227 A1 sind Laborverbrauchsartikel aus einem Kunststoffmaterial mit einer flüssigkeitsabweisenden Beschichtung bekannt, welche auf ein Laborverbrauchsartikel, insbesondere auf eine Pipettenspitze, aufgebracht wird, um zu vermeiden, dass Reste der zu untersuchenden Flüssigkeit in dem Laborverbrauchsartikel verbleiben. Insbesondere bei biochemischen und chemischen Reaktionen, die beispielsweise zu Forschungs- oder Analysezwecken und insbesondere in der medizinischen oder forensischen Diagnostik durchgeführt werden, werden häufig sehr kleine Mengen an Proben oder Reagenzien verwendet. Das Zurückhalten von Proben oder Reagenzien in einem signifikanten Anteil auf der Oberfläche von Laborgeräten, die während der Proben- oder Reagenzienhandhabung in direkten Kontakt mit ihnen kommen, kann die Ergebnisse erheblich beeinflussen. Da viele der Reagenzien extrem kostspielig sind, ergeben sich aus dem Reagenzienverlust auf diese Weise wirtschaftliche Auswirkungen.

Nachteilig an den aus dem Stand der Technik bekannten Lösungen ist jedoch, dass sich aus dem Kunststoff des Laborverbrauchsartikels bei Kontakt mit flüssigen Medien oder Proben Bestandteile oder Zusatzstoffe herauslösen können, welche die Probe kontaminieren. Diese Kontaminationen können insbesondere biologische Essays verfälschen oder inhibieren und somit Ergebnisse verfälschen oder schlimmstenfalls unbrauchbar machen.

Der Erfindung liegt nun die Aufgabe zugrunde, das Herauslösen von Bestandteilen oder Zusatzstoffen aus dem Kunststoffmaterial des Laborverbrauchsartikels und gleichzeitig einen Reagenzienverlust durch Anhaften von Resten der Probe und/oder des flüssigen Mediums in dem Laborverbrauchsartikel zu vermeiden.

Diese Aufgabe wird durch einen Laborverbrauchsartikel mit einem Grundkörper aus einem Polymermaterial und einer zumindest abschnittsweise auf den Grundkörper aufgebrachten flüssigkeitsabweisenden Beschichtung gelöst. Erfindungsgemäß ist vorgesehen, dass zwischen dem Grundkörper und der flüssigkeitsabweisenden Beschichtung eine Barriereschicht ausgebildet ist, welche ein Herauslösen und/oder Freisetzen von in dem Grundkörper enthaltenen Kontaminationen oder eine Diffusion der im Grundkörper enthaltenen Kontaminationen in die flüssigkeitsabweisende Beschichtung verhindert. Unter einem Laborverbrauchsartikel ist in diesem Zusammenhang insbesondere ein Laboreinwegartikel, beispielsweise Probenröhrchen, Schraubdeckelgefäße, Pipettenspitzen, Blut- oder Urinbeutel, Laborgefäße, Zentrifugenröhrchen oder ein Blutentnahmeröhrchen zu verstehen. Diese Liste ist nicht abschließend und kann um weitere Laborverbrauchsartikel ergänzt werden. Generell umfasst der Begriff "Laborverbrauchsartikel" jedes Gerät, das im Verlauf des normalen Laborgebrauchs mit flüssigen Reagenzien, polaren und unpolaren Lösungsmitteln oder Proben in Kontakt kommt, einschließlich der Verwendung beispielsweise in medizinischen Umgebungen wie Krankenhäusern oder Forschungslaboren. Im Allgemeinen handelt es sich dabei um Einweg-Verbrauchsartikel zum Einmalgebrauch, obwohl einige wiederholt verwendet werden können, beispielsweise nach dem Waschen oder Reinigen irgendeiner Art.

Durch eine Barriereschicht kann ein Herauslösen von in dem Grundkörper enthaltenen Kontaminationen, insbesondere von unverbundenen Polymerbausteinen, Lösungsmitteln oder Zusatzstoffen, welche die Verarbeitung des Polymermaterials des Grundkörpers begünstigen, verhindert werden. Dabei ist die Barriereschicht dünn und flexibel genug, um bei einer Verformung des Laborverbrauchsartikels, beispielsweise beim Aufstecken einer Pipettenspitze auf eine Pipette oder bei der Verformung eines Blut- oder Urinbeutels beim Befüllen, Transportieren oder Entleeren, nicht von dem Grundkörper abzuplatzen.

Die flüssigkeitsabweisende Beschichtung verbessert insbesondere die Oberfläche des Laborverbrauchsartikels, indem sie ihn öl- und wasserabweisender macht und in einigen Fällen zu einer ultrahydrophoben oder omniphoben Oberfläche macht.

Zudem wird durch die flüssigkeitsabweisende Beschichtung auf der Barriereschicht der Kontakt der Barriereschicht mit der Flüssigkeit vermieden. Ein Kontakt der Flüssigkeit, insbesondere einer wässrigen Lösung, mit der Barriereschicht ist für Anwendungen im Life-Science-Bereich kritisch, da die Barriereschicht in Kontakt mit einer Flüssigkeit Bestandteile wie Metallionen freisetzten kann, welche die biologischen Eigenschaften von Proben beeinflussen können.

Durch die in den abhängigen Ansprüchen aufgeführten Merkmale sind vorteilhafte Verbesserungen und Weiterentwicklungen des im unabhängigen Anspruch aufgeführten Laborverbrauchsartikels möglich.

In bevorzugter Ausgestaltung des Laborverbrauchsartikels ist vorgesehen, dass die Barriereschicht eine anorganische Barriereschicht ist. Anorganische Beschichtungen bieten einen besonderen Schutz gegen die Diffusion von Polymerresten oder sonstigen im Grundmaterial eingeschlossenen Kontaminationen. Ferner verhindern anorganische Barriereschichten das Herauslösen von Zusatzstoffen oder Verunreinigungen aus dem Grundmaterial.

In einer vorteilhaften Ausgestaltung des Laborverbrauchsartikels ist vorgesehen, dass die Barriereschicht eine diffusionsdichte Keramikbeschichtung ist. Keramische Beschichtungen bieten neben der Sperrfunktion eine sehr hohe mechanische Festigkeit und eine hohe Verschließrobustheit. Somit kann auch bei einer vergleichsweise unvorsichtigen Handhabung des Laborverbrauchsartikels sichergestellt werden, dass die Barriereschicht nicht beschädigt wird. Bevorzugt ist dabei, wenn die diffusionsdichte Keramikbeschichtung eine Metalloxidbeschichtung ist.

Besonders bevorzugt ist eine diffusionsdichte Aluminiumoxidbeschichtung als Barriereschicht. Eine Aluminiumoxidbeschichtung hat sich durch eine einfache und im Vergleich zu anderen keramischen Beschichtungen vergleichsweise kostengünstige Herstellung sowie eine funktionssichere Sperrfunktion als besonders günstig herausgestellt. Durch die flüssigkeitsabweisende Beschichtung auf der Barriereschicht wird ein Kontakt einer Flüssigkeit, insbesondere einer wässrigen Lösung, mit der Barriereschicht verhindert, sodass die Gefahr eines Herauslösens von Aluminiumionen aus der Barriereschicht vermieden wird. Da Aluminiumionen häufig besonders schädlich für Biomoleküle sind, kann der vorgeschlagene Laborverbrauchsartikel auch für auf Aluminiumionen empfindliche Biomoleküle eingesetzt werden.

In einer vorteilhaften Ausgestaltung des Laborverbrauchsartikels ist vorgesehen, dass die Barriereschicht eine Schichtdicke von 0,8 Nanometer bis 200 Nanometer aufweist. Durch die dünne Barriereschicht ist diese optisch nicht zu sehen und beeinflusst somit nicht das Design des Laborverbrauchsartikels. Trotz der dünnen Beschichtung kann aber funktionssicher ein Herauslösen von Kontaminationen oder eine Diffusion von Zusatzstoffen aus dem Grundmaterial des Laborverbrauchsartikels in die flüssigkeitsabweisende Beschichtung verhindert werden.

Bevorzugt ist dabei eine Barrierschicht mit einer Schichtdicke von einem Nanometer bis 50 Nanometer.

Besonders bevorzugt ist eine Barriereschicht mit einer Schichtdicke von einem Nanometer bis 20 Nanometer. Barriereschichten mit einer Schichtdicke von einem Nanometer bis 20 Nanometer lassen sich mit geringem Zeitaufwand und daher kostengünstig herstellen. Zudem reduziert eine dünne Barriereschicht die Gefahr von Rissen oder Abplatzern der Beschichtung bei einer höheren mechanischen Beanspruchung des Laborverbrauchsartikels, beispielsweise beim Aufstecken einer Pipettenspitze auf eine Pipette.

Gemäß einer bevorzugten Ausführungsform des Laborverbrauchsartikels ist vorgesehen, dass die Barriereschicht mittels eines Atomic-Layor-Deposition-Verfahrens auf den Grundkörper aufgebracht ist. Durch ein Atomic-Layor-Deposition-Verfahren lässt sich eine besonders dünne Barriereschicht auf den Grundkörper aufbringen. Besonders bevorzugt ist dabei, wenn die Barriereschicht aus der Gasphase abgeschieden wird. Durch das Abscheiden aus der Gasphase lässt sich eine besonders dünne und gleichmäßige Barriereschicht auf den Grundkörper des Laborverbrauchsartikels auftragen. Das Atomic-Layer-Deposition-Verfahren ermöglicht absolut dichte Barriereschichten ohne jegliche Pinholes.

In einer bevorzugten Ausgestaltung des Laborverbrauchsartikels ist vorgesehen, dass die flüssigkeitsabweisende Beschichtung eine biokompatible hydrophobe oder biokompatible omniphobe Beschichtung ist. Unter einer biokompatiblen Beschichtung ist in diesem Zusammenhang eine Beschichtung zu verstehen, welche die Anforderungen der EN ISO 10993-1 für die biologische Beurteilung von Medizinprodukten erfüllt. Dabei ist die biokompatible Beschichtung zumindest wasserabweisend, vorzugsweise wasser- und fettabweisend um ein möglichst geringes Anhaften von Reagenzresten in dem Laborverbrauchsartikel sicherzustellen.

Besonders vorteilhaft ist dabei, wenn die flüssigkeitsabweisende Beschichtung eine superhydrophobe oder ultrahydrophobe Beschichtung ist. Die Begriffe superhydrophob und ultrahydrophob werden in der Literatur als Synonyme für wasserabweisende Beschichtungen mit einem Kontaktwinkel von mehr als 90°, vorzugsweise von mehr als 150°, verwendet. Als Kontaktwinkel wird der Winkel bezeichnet, den ein Flüssigkeitstropfen auf der Oberfläche eines Feststoffs zu dieser Oberfläche bildet. Oberflächenbeschichtungen, die zu einem Kontaktwinkel von mehr als 150° führen, werden auch als Oberflächen mit Lotuseffekt beworben.

In einer vorteilhaften Ausführungsform des Laborverbrauchsartikels ist vorgesehen, dass die flüssigkeitsabweisende Beschichtung eine Polymerbeschichtung ist, welche mittels eines Plasmabeschichtungsverfahrens auf die Barriereschicht aufgetragen ist.

Besonders vorteilhaft ist es, wenn die flüssigkeitsabweisende Beschichtung mittels eines PECVD-Verfahrens (Plasma-Enhanced-Chemical-Vapor-Deposition-Verfahren) auf die Barriereschicht aufgetragen ist. Die flüssigkeitsabweisende Beschichtung verhindert das die zu untersuchende Flüssigkeit oder Probe mit der Barriereschicht in Kontakt kommt. Durch eine PECVD-Verfahren kann auf einfache Art und Weise eine dünne flüssigkeitsabweisende Beschichtung auf die Barriereschicht aufgetragen werden, sodass sich der Laborverbrauchsartikel kostengünstig herstellen lässt.

Die bevorzugte Schichtdicke der flüssigkeitsabweisenden Beschichtung liegt dabei bei einer Schichtdicke von 1 Nanometer bis 500 Nanometer. Die flüssigkeitsabweisende Beschichtung kann beispielsweise beim Aufsetzen des Laborverbrauchsartikels oder beim Einfüllen der Probe mechanisch belastet werden. Als Beispiel sei das Aufsetzen einer Pipettenspitze auf eine Pipette genannt. Dabei sollte die Schichtdicke so ausgestaltet werden, dass zum einen die flüssigkeitsabweisenden Eigenschaften sichergestellt werden und zum anderen erreicht wird, dass eine einfache mechanische Belastung nicht zu einem derart starken Abrieb der flüssigkeitsabweisenden Beschichtung führt, dass die Barriereschicht freigelegt wird und in Kontakt mit der Probe kommt.

Bevorzugt ist dabei, dass die Schichtdicke der flüssigkeitsabweisenden Beschichtung dicker als die Schichtdicke der Barriereschicht ist. Dadurch kann ein begrenzter mechanischer Abtrag der flüssigkeitsabweisenden Beschichtung zugelassen werden, ohne dass dies zu einem Freilegen der Barriereschicht führt.

Besonders bevorzugt sind Schichtdicken der flüssigkeitsabweisenden Beschichtung von 5 Nanomenter bis 50 Nanometer. Der Schichtbereich zwischen 5 Nanometern und 50 Nanometern bietet einen bestmöglichen Kompromiss bezüglich der Beschichtungszeit und der Widerstandsfähigkeit der flüssigkeitsabweisenden Beschichtung.

Gemäß einer vorteilhaften Ausgestaltung ist die flüssigkeitsabweisende Beschichtung ein Polymerisat einer Acrylverbindung mit einer chemisch gebundenen Perfluoralkylgruppe.

In einer bevorzugten Ausgestaltung des Laborverbrauchsartikels weist dieser einen Aufnahmebereich zur Aufnahme einer Probe oder einer Flüssigkeit und einen Haltebereich zum Halten und/oder Transportieren des Laborverbrauchsmaterials auf, wobei das Laborverbrauchsmaterial zumindest im Aufnahmebereich mit einer flüssigkeitsabweisenden Beschichtung und einer Barriereschicht versehen ist. Dabei weist der Aufnahmebereich eine der Flüssigkeit und/oder Probe zugewandte erste Oberfläche auf, welche bei einem Röhrchen, einem Beutel, einem Gefäß oder einer Pipettenspitze auch als Innenwand bezeichnet wird. Der Haltebereich weist eine der Flüssigkeit und/oder Probe abgewandte zweite Oberfläche auf, welche auch unbeschichtet ausgeführt werden kann, wodurch sich gegebenenfalls die Prozesszeit bei der Beschichtung verkürzen lässt. Die beschichtungsfreie Oberfläche an dem Haltebereich kann beispielsweise zum Halten des Laborverbrauchsartikels beim Auftragen der Barriereschicht und/oder der flüssigkeitsabweisenden Beschichtung notwendig sein. Alternativ kann der beschichtungsfreie Bereich auch durch eine Maskierung des Laborverbrauchsartikels hergestellt werden.

Bevorzugt stammt der Laborverbrauchsartikel aus der Gruppe der nachfolgenden Gegenstände: Laborgefäß, Laborbehälter, Pipettenspitze, Bürette, Schale, Küvette, Röhrchen, Beutel, Filtermembran, Nadel, Immunoassay-Mikrotiterplatten-Produkt, Injektionsspritze oder Einweg-Bioreaktor. Solche Laborverbrauchsartikel werden in hochsensiblen Laborbereichen eingesetzt, bei denen eine Kontamination der Flüssigkeit und/oder der Probe besonders negative Auswirkungen hat. Besonders bevorzugt stammt der Laborverbrauch aus der Gruppe der nachfolgenden Gegenstände: Pipettenspitze, Zentrifugenröhrchen, Probenröhrchen, Versuchsröhrchen, Blutentnahmeröhrchen, Flachbodenröhrchen, Probenampulle, Probenfläschchen, Schraubverschlussbehälter, Wägebehälter, Blut- oder Urinbeutel sowie Einweg-Bioreaktoren.

Diese können aus einer Vielzahl von Materialien hergestellt werden, wie wärmehärtbaren Harzen, thermoplastischen Harzen, Polyolefinen, Acetalen, polyamidischen Harzen, Acrylharzen (PMMA), Kohlenwasserstoffen oder Fluorkohlenwasserstoffen wie beispielsweise Polyethylen (PE), Polypropylen (PP), Polymethylpenten (PMP oder TPX®), Polystyrol (PS), Polyvinylchlorid (PVC), Polyoxymethylen (POM), Nylon (PA6), Polycarbonate (PC), Polytetrafluorethylen (PTFE), Tetrafluorethylenperfluorpropylen (FEP), Perfluoralkoxy (PFA) PVDF), Ethylentetrafluorethylen (ETFE) oder Ethylen-Cholortrifluorethylen (E-CTFE).

Ein weiterer Teilaspekt der Erfindung betrifft ein Verfahren zur Herstellung eines solchen Laborverbrauchsartikels, wobei der Grundkörper aus einem Polymerwerkstoff hergestellt wird, auf den Grundkörper die Barriereschicht aufgetragen wird und auf die Barriereschicht eine flüssigkeitsabweisende Beschichtung aufgebracht wird. Dabei wird der Laborverbrauchsartikel in einem Spritzguss- oder Tiefziehprozess aus einem Polymermaterial hergestellt. Anschließend wird die Barriereschicht vorzugsweise mittels eines Atomic-Layer-Deposition-Verfahrens auf den Grundkörper aufgetragen und in einem weiteren Beschichtungsprozess, vorzugsweise mittels eines PECVD-Verfahrens (Plasma-Enhanced-Chemical-Vapor-Deposition-Verfahren), die flüssigkeitsabweisende Beschichtung auf die Barriereschicht aufgebracht. Somit wird ein Laborverbrauchsartikel hergestellt, welcher eine flüssigkeitsabweisende Oberfläche aufweist und frei von Kontaminationen ist.

Die Erfindung wird nachfolgend in Ausführungsbeispielen anhand der zugehörigen Zeichnungen erläutert. Gleiche Bauteile oder Bauteile mit der gleichen Funktion sind dabei in den unterschiedlichen Zeichnungen mit denselben Bezugsziffern gekennzeichnet. Es zeigen:
- Figur 1: ein bevorzugtes Ausführungsbeispiel eines erfindungsgemäßen Laborverbrauchsartikels;
- Figur 2: ein weiteres bevorzugtes Ausführungsbeispiel eines erfindungsgemäßen Laborverbrauchsartikels;
- Figur 3: ein weiteres bevorzugtes Ausführungsbeispiel eines erfindungsgemäßen Laborverbrauchsartikels mit einem Grundkörper aus einem Polymermaterial, einer Barriereschicht und einer flüssigkeitsabweisenden Beschichtung;
- Figur 4: weitere bevorzugte Ausführungsbeispiele von erfindungsgemäßen Laborverbrauchsartikeln;
- Figur 5: eine Anlagenkonstellation zur Herstellung eines erfindungsgemäßen Laborverbrauchsartikels; und
- Figur 6: ein Ablaufdiagramm zur Herstellung eines erfindungsgemäßen Laborverbrauchsartikels.

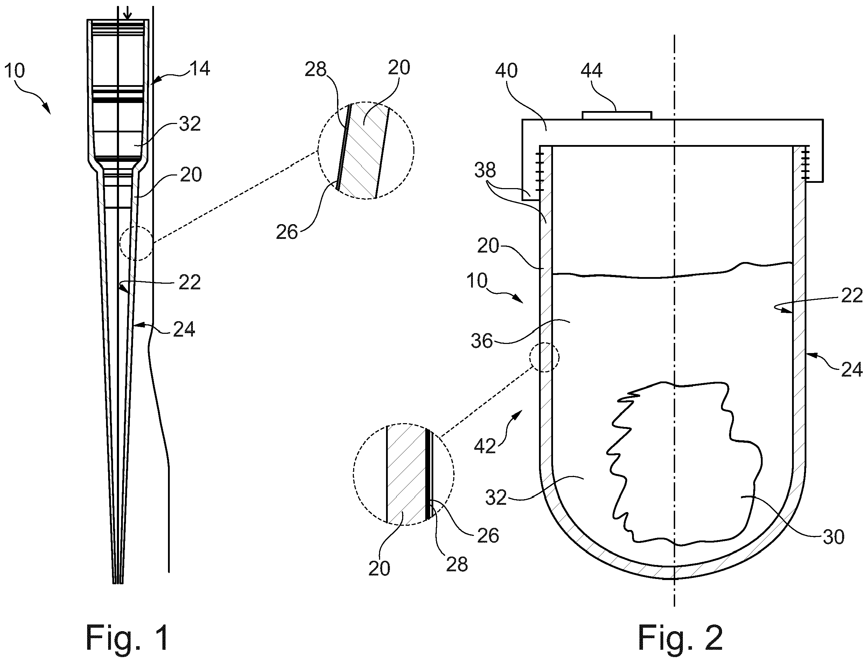

Figur 1 zeigt einen erfindungsgemäßen Laborverbrauchsartikel 10 in Form einer Pipettenspitze 14. Die Pipettenspitze 14 weist einen Grundkörper 20 aus einem Polymermaterial, beispielsweise Polypropylen (PP) oder Polyethylen (PE), auf. Der Grundkörper 20 weist eine einer Flüssigkeit 32 zugewandte Innenseite 22 und eine Außenseite 24 auf. Auf den Grundkörper 20 ist zumindest auf der der Flüssigkeit 32 zugewandten Innenseite 22, vorzugsweise auf dem gesamten Grundkörper 20, eine Barriereschicht 28 aufgebracht. Auf diese Barriereschicht 28 ist eine flüssigkeitsabweisende Beschichtung 26 aufgebracht. Die Barriereschicht 28 verhindert, dass in dem Grundkörper 20 enthaltene Kontaminationen, insbesondere Zusatzstoffe oder Polymerreste, in die flüssigkeitsabweisende Beschichtung 26 diffundieren und somit in Kontakt mit der zu untersuchenden Flüssigkeit 32 treten. Die flüssigkeitsabweisende Beschichtung 26 verhindert, dass die Flüssigkeit 32 in Kontakt mit der Barriereschicht 28 kommt. Die flüssigkeitsabweisende Beschichtung 26 ist vorzugsweise als ultrahydrophobe oder omniphobe Beschichtung ausgebildet und verleiht zumindest der der Flüssigkeit zugewandten Innenseite 22 einen Abperleffekt nach Art des Lotuseffektes. Somit kann die Barriereschicht 28 nach rein technischen Gesichtspunkten ausgewählt werden und muss selbst nicht biokompatibel oder flüssigkeitsabweisend sein.

Figur 2 zeigt ein weiteres Ausführungsbeispiel eines Laborverbrauchsartikels 10 in Form eines Probengefäßes 42 mit einem Schraubdeckel 40. Das Probengefäß 42 weist einen Grundkörper 20 aus einem Polymermaterial, beispielsweise Polypropylen (PP) oder Polyethylen (PE), auf. Der Grundkörper 20 weist eine einer Probe 30 zugewandte Innenseite 22 und eine Außenseite 24 auf. Auf den Grundkörper 20 ist zumindest auf der der Probe 30 zugewandten Innenseite 22, vorzugsweise auf dem gesamten Grundkörper 20, eine Barriereschicht 28 aufgebracht. Auf diese Barriereschicht 28 ist eine flüssigkeitsabweisende Beschichtung 26 aufgebracht. Die Barriereschicht 28 verhindert, dass in dem Grundkörper 20 enthaltene Kontaminationen, insbesondere Zusatzstoffe oder Polymerreste, in die flüssigkeitsabweisende Beschichtung 26 diffundieren und somit in Kontakt mit der zu untersuchenden Probe 30 treten. Die flüssigkeitsabweisende Beschichtung 26 verhindert, dass die Probe 30 in Kontakt mit der Barriereschicht 28 kommt. Die Innenseite 22 des Probengefäßes 42 bildet einen Aufnahmebereich 36 für die Probe 30 aus. Die Außenseite 24 bildet einen Haltebereich 38 aus, an welcher das Probengefäß 42 zur Beschichtung und/oder zum Handling im Labor aufgenommen oder angefasst werden kann.

Das offene Ende des Probengefäßes 42 ist durch einen Schraubdeckel 40 verschließbar. Dabei kann auf dem Probengefäß 42 und/oder dem Schraubdeckel 40 ein maschinenlesbarer Barcode aufgebracht sein, um die Probe 30 zu identifizieren und/oder zurückzuverfolgen. Alternativ kann das Probengefäß auch durch eine andere Art von Verschluss, insbesondere durch einen anderen Deckel, verschlossen werden.

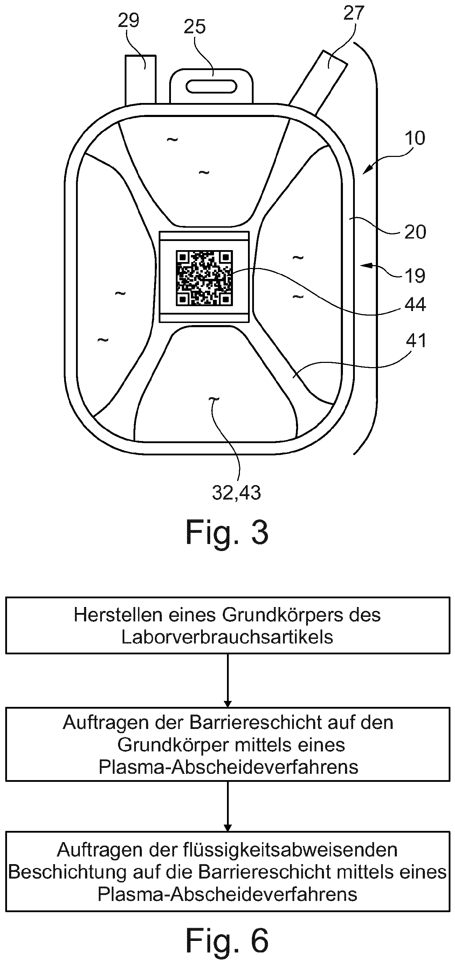

In Figur 3 ist ein Beutel 19 zur Aufnahme einer Flüssigkeit 31, insbesondere ein Blutbeutel oder ein Urinbeutel, mit einem Grundkörper 20 aus einem Polymermaterial dargestellt. Der Beutel 19 ist mit einer Flüssigkeit 32, beispielsweise Blut 43, befüllbar. An einer Innenseite 22 des Beutels ist auf den Grundkörper 20 eine Barriereschicht 28 aufgebracht. Auf diese Barriereschicht ist eine flüssigkeitsabweisende Beschichtung 26 aufgebracht, sodass eine in den Beutel 19 eingefüllte Flüssigkeit 31 ausschließlich mit der flüssigkeitsabweisenden Beschichtung 26 in Kontakt steht. An dem Beutel 19 ist ferner eine Schlaufe 25 ausgebildet, um den Beutel 19 für eine vereinfachte Handhabung aufhängen zu können. Ferner sind an dem Beutel 19 eine erste Anschlussstelle 27 und eine zweite Anschlussstelle 29 ausgebildet, über welche der Beutel 19 mit einer Flüssigkeit 32, insbesondere Blut 43, befüllt werden kann. An dem Beutel 19 können Versteifungs-oder Verstärkungselemente 41 vorgesehen sein, um den Beutel 19 vor einer mechanischen Beschädigung zu schützen. Ferner ist an dem Beutel eine Beschriftungsfläche ausgebildet, auf welche eine manuelle oder maschinelle Beschriftung, ein Etikett und/oder ein Barcode 44 aufgebracht werden können.

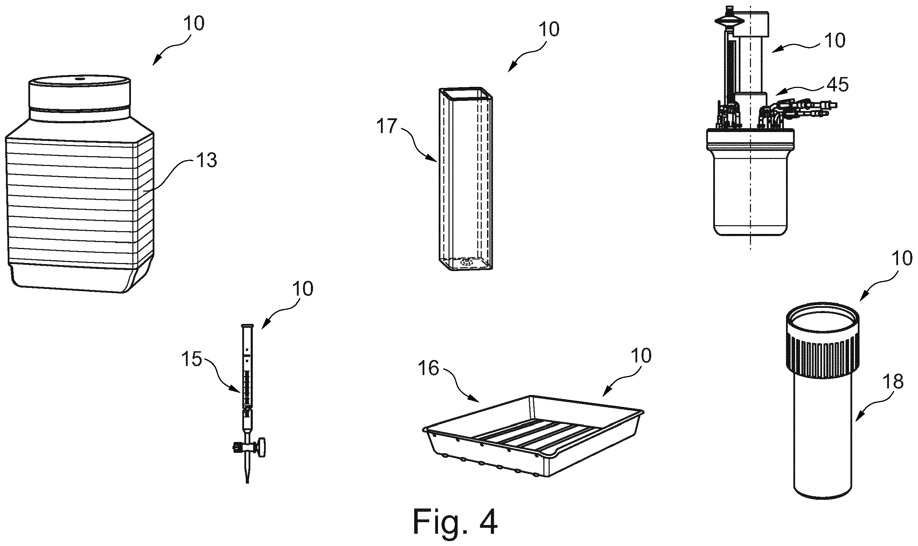

In Figur 4 sind weitere erfindungsgemäße Laborverbrauchsartikel 10 dargestellt, welche zumindest auf ihrer der Probe 30 und/oder Flüssigkeit 32 zugewandten Innenseite 22 oder Oberfläche eine Barriereschicht 28 auf dem Grundkörper 20 und auf dieser Barriereschicht 28 eine flüssigkeitsabweisende Beschichtung 26, insbesondere eine ultrahydrophobe oder omniphobe Beschichtung, aufgebracht ist. In Figur 4 sind exemplarisch ein Laborbehälter 13, eine Bürette 15, eine Schale 16, eine Küvette 17, ein Röhrchen18 und ein Einweg-Bioreaktor 45 dargestellt. Die Aufzählung der Laborverbrauchsartikel 10 an dieser Stelle ist jedoch nicht abschließend, sodass weitere Laborverbrauchartikel 10, insbesondere Laboreinwegartikel 34, ebenfalls aus einem Grundkörper 20 aus einem Polymermaterial, einer Barriereschicht 28 auf dem Grundkörper 20 und einer auf der Barriereschicht 28 aufgetragenen flüssigkeitsabweisenden Beschichtung 26 im Rahmen der Erfindung ebenfalls mit betrachtet werden sollen.

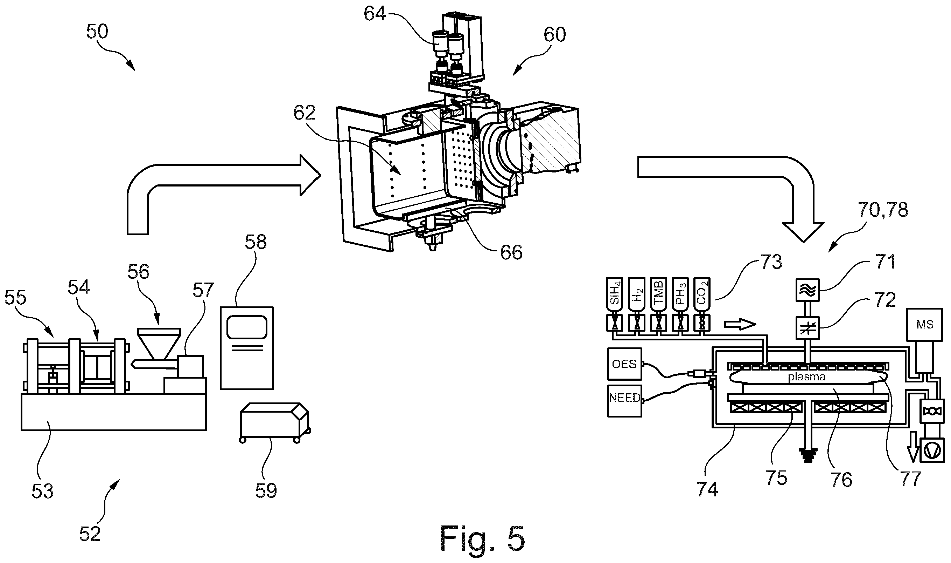

In Figur 5 ist eine Anlagenkonstellation 50 zur Herstellung eines erfindungsgemäßen Laborverbrauchsartikel 10. Die Anlagenkonstellation 50 umfasst eine Spritzgussmaschine 52 mit einem Spritzgusswerkzeug 54 zur Herstellung eines Grundkörpers 20 oder mehrerer Grundkörper 20 von Laborverbrauchsartikel(n) 10, eine erste Beschichtungsanlage 60 zum Auftragen der Barriereschicht 28 auf den oder die Grundkörper 20 sowie einer zweiten Beschichtungsanlage 70 zum Auftragen eines flüssigkeitsabweisenden Beschichtung 26 auf die jeweilige Barriereschicht 28 des Laborverbrauchsartikels 20. Die Spritzgussmaschine 52 weist eine Maschinenbett 53 auf, auf welchem die Schließmechanik 55 für das Spritzgusswerkzeug 54, ein Plastifizierungsaggregat 56 und Fördereinheit 57. Der Spritzgussmaschine 52 sind eine Steuerungseinheit 58 sowie eine Temperiervorrichtung 59 zugeordnet, um die Werkzeugtemperatur, die Temperatur des Polymermaterials, den Spritzdruck sowie weitere Prozessparameter zu steuern. Dabei ist das Spritzgusswerkzeug 54 vorzugsweise als Mehrfach-Werkzeug mit einer Vielzahl von Kavitäten ausgeführt, um mehrere Laborverbrauchsartikel 10 gleichzeitig herstellen zu können.

Die erste Beschichtungsanlage 60 ist vorzugsweise als Atomic-Layer-Deposition-Beschichtungsanlage 61 ausgeführt. Die erste Beschichtungsanlage 60 umfasst eine Beschichtungskammer 62, in welcher die Barriereschicht 28 aus einem Plasma auf einen in der Beschichtungskammer 62 angeordneten Träger 66 abgeschieden wird, welcher eine Mehrzahl von Laborverbrauchsartikeln 10 trägt. Alternativ ist es insbesondere bei größeren Laborverbrauchsartikeln 10 auch denkbar, dass diese jeweils einzeln in die Beschichtungskammer 62 eingebracht und dort einzeln beschichtet werden.

Die zweite Beschichtungsanlage 70 ist vorzugsweise als PECVD-Beschichtungsanlage 78 ausgeführt. Die zweite Beschichtungsanlage 70 umfasst ein RF-Generator 71 sowie eine Schalt- oder Steuereinheit 72. Die zweite Beschichtungsanlage 70 umfasst ferner eine Beschichtungskammer 74, in welcher ein Heizelement 75 angeordnet ist. Ferner ist in der Beschichtungskammer 74 eine Aufnahme für ein Substrat oder einen Substratträger 76 vorgesehen, welcher einem Plasma 77. An die Beschichtungskammer 74 ist eine Gasversorgung 73 angeschlossen, um der Beschichtungskammer 74 ein entsprechendes Gas- oder Gasgemisch zuzuführen, aus welchem über die Plasmaabscheidung eine flüssigkeitsabweisende Beschichtung 26 auf die Barriereschicht 28 des Laborverbrauchsartikels 10 aufgetragen wird.

Nachfolgend wird der Herstellungs- und Beschichtungsprozess am Beispiel von Pipettenspitzen 14 näher erläutert.

In Figur 6 ist ein Ablaufdiagramm zur Durchführung eines erfindungsgemäßen Verfahrens zur Herstellung eines Laborverbrauchsartikels 10 dargestellt. In einem ersten Verfahrensschritt wird der Grundkörper 20 des Laborverbrauchsartikels 10 in einem Spritzguss- oder Tiefziehprozess hergestellt. Zur Herstellung von Pipettenspitzen 14 sind hierzu insbesondere Spritzgusswerkzeuge 54 mit einer Vielzahl von Kavitäten vorgesehen, welche die Herstellung einer Vielzahl von Pipettenspitzen 14 in einem Verfahrensschritt ermöglicht. Ein solches Werkzeug weist vorzugsweise mindestens 16, vorzugsweise mindestens 32 Kavitäten auf, um eine geringe Zykluszeit und damit verbunden geringe Produktionskosten zur Herstellung des Grundkörpers 20 der Pipettenspitze 14 zu erreichen. In einem zweiten Verfahrensschritt wird die Barriereschicht 28 mittels eines Plasmaabscheidungsverfahrens, vorzugsweise mittels eines Atomic-Layer-Deposition-Verfahrens, auf eine Oberfläche des Grundkörpers 20 aufgebracht. In einem dritten Verfahrensschritt wird die flüssigkeitsabweisende Beschichtung 26 mittels eines weiteren Plasmaabscheideverfahrens, insbesondere mittels eines PECVD-Verfahrens, auf die Barriereschicht 28 aufgetragen, um die flüssigkeitsabweisende Eigenschaft des Laborverbrauchsartikels 10 zu erreichen.

### Bezugszeichenliste

- 10: Laborverbrauchsartikel
- 12: Laborgefäß
- 13: Laborbehälter
- 14: Pipettenspitze
- 15: Bürette
- 16: Schale
- 17: Küvette
- 18: Röhrchen
- 19: Beutel

- 20: Grundkörper
- 22: Innenseite / der Probe zugewandte Seite
- 24: Außenseite
- 25: Schlaufe
- 26: flüssigkeitsabweisende Beschichtung
- 27: erste Anschlussstelle
- 28: Barriereschicht
- 29: zweite Anschlussstelle

- 30: Probe
- 32: Flüssigkeit
- 34: Laboreinwegartikel
- 36: Aufnahmebereich
- 38: Haltebereich
- 40: Schraubdeckel
- 41: Versteifungselement
- 42: Probengefäß
- 43: Blut
- 44: Barcode
- 45: Einwegbioreaktor

- 50: Anlagenkonstellation
- 52: Spritzgussmaschine
- 53: Maschinenbett
- 54: Spritzgusswerkzeug
- 55: Schließmechanik
- 56: Plastifizierungsaggregat
- 57: Fördereinheit
- 58: Steuerungseinheit
- 59: Temperiervorrichtung

- 60: erste Beschichtungsanlage
- 61: ALD-Beschichtungsanlage
- 62: Beschichtungskammer
- 64: Gaszufuhr
- 66: Träger

- 70: zweite Beschichtungsanlage
- 71: RF-Generator
- 72: Schalteinheit
- 73: Gasversorgungseinheit
- 74: Beschichtungskammer
- 75: Heizelement
- 76: Substratträger
- 77: Plasma
- 78: PECVD-Beschichtungsanlage

## Patentansprüche

1. Laborverbrauchsartikel (10) mit einem Grundkörper (20) aus einem Polymermaterial und einer zumindest abschnittsweise auf den Grundkörper (20) aufgebrachten flüssigkeitsabweisenden Beschichtung (26), **dadurch gekennzeichnet, dass** zwischen dem Grundkörper (20) und der flüssigkeitsabweisenden Beschichtung (26) eine Barriereschicht (28) ausgebildet ist, welche ein Herauslösen und/oder Freisetzen von in dem Grundkörper (20) enthaltenen Kontaminationen oder eine Diffusion der im Grundkörper (20) enthaltenen Kontaminationen in die flüssigkeitsabweisende Beschichtung (26) verhindert.

2. Laborverbrauchsartikel (10) nach Anspruch 1, **dadurch gekennzeichnet, dass** die Barriereschicht (28) eine anorganische Barriereschicht ist.

3. Laborverbrauchsartikel (10) nach Anspruch 1, **dadurch gekennzeichnet, dass** die Barriereschicht (28) eine diffusionsdichte Keramikbeschichtung, insbesondere eine Metalloxidbeschichtung, ist.

4. Laborverbrauchsartikel (10) nach Anspruch 1, **dadurch gekennzeichnet, dass** die Barriereschicht (28) eine diffusionsdichte Aluminiumoxidbeschichtung ist.

5. Laborverbrauchsartikel (10) nach einem der Ansprüche 1 bis 4, **dadurch gekennzeichnet, dass** die Barriereschicht (28) eine Schichtdicke von 0,8 Nanometer bis 200 Nanometer aufweist.

6. Laborverbrauchsartikel (10) nach einem der Ansprüche 1 bis 5, **dadurch gekennzeichnet, dass** die Barriereschicht (28) mittels eines Atomic-Layer-Deposition-Verfahrens auf den Grundkörper (20) aufgebracht ist.

7. Laborverbrauchsartikel (10) nach Anspruch 6, **dadurch gekennzeichnet, dass** die Barriereschicht (28) aus der Gasphase abgeschieden wird.

8. Laborverbrauchsartikel (10) nach einem der Ansprüche 1 bis 7, **dadurch gekennzeichnet, dass** die flüssigkeitsabweisende Beschichtung (26) eine biokompatible hydrophobe oder biokompatible omniphobe Beschichtung ist.

9. Laborverbrauchsartikel (10) nach Anspruch 8, **dadurch gekennzeichnet, dass** die flüssigkeitsabweisende Beschichtung (26) eine superhydrophobe oder ultrahydrophobe Beschichtung ist.

10. Laborverbrauchsartikel (10) nach einem der Ansprüche 1 bis 9, **dadurch gekennzeichnet, dass** die flüssigkeitsabweisende Beschichtung (26) eine Polymerbeschichtung ist, welche mittels eines Plasmabeschichtungsverfahrens, insbesondere mittels eines PECVD-Verfahrens (Plasma-Enhanced Chemical Vapor Deposition Verfahren) auf die Barriereschicht (28) aufgetragen ist.

11. Laborverbrauchsartikel (10) nach einem der Ansprüche 1 bis 10, **dadurch gekennzeichnet, dass** die flüssigkeitsabweisende Beschichtung (26) eine Schichtdicke von 1 Nanometer bis 500 Nanometer aufweist.

12. Laborverbrauchsartikel (10) nach einem der Ansprüche 1 bis 11, **dadurch gekennzeichnet, dass** die flüssigkeitsabweisende Beschichtung (26) ein Polymerisat einer Acrylverbindung mit einer chemisch gebundenen Perfluoralkylgruppe ist.

13. Laborverbrauchsartikel (10) nach einem der Ansprüche 1 bis 11, **dadurch gekennzeichnet, dass** der Laborverbrauchsartikel (10) einen Aufnahmebereich (36) zur Aufnahme einer Probe (30) oder einer Flüssigkeit (32) und einen Haltebereich (38) zum Halten und/oder Transportieren des Laborverbrauchsartikels (10) aufweist, wobei der Laborverbrauchsartikel (10) zumindest im Aufnahmebereich (36) mit einer flüssigkeitsabweisenden Beschichtung (26) und einer Barriereschicht (28) versehen ist.

14. Laborverbrauchsartikel (10) nach einem der Ansprüche 1 bis 13, **dadurch gekennzeichnet, dass** der Laborverbrauchartikel (10) ein Artikel aus der Gruppe der nachfolgenden Gegenstände ist: Laborgefäß (12), Laborbehälter (13), Pipettenspitze (14), Bürette (15), Schale (16), Küvette (17) Röhrchen (18), Beutel (19), Filtermembran, Nadel, Immunoassay-Mikrotiterplatten-Produkt, Injektionsspritze, Einwegbioreaktor (45), insbesondere Zentrifugenröhrchen, Probenröhrchen, Versuchsröhrchen, Blutentnahmeröhrchen, Flachbodenröhrchen, Probenampulle, Probenfläschchen, Schraubverschlussbehälter, Wägebehälter, Blutbeutel oder Urinbeutel.

15. Verfahren zur Herstellung eines Laborverbrauchsartikels (10) nach einem der Ansprüche 1 bis 14, **dadurch gekennzeichnet, dass** der Grundkörper (20) aus einem Polymerwerkstoff hergestellt wird, auf den Grundkörper (20) die Barriereschicht (28) aufgetragen wird und auf die Barriereschicht (28) eine flüssigkeitsabweisende Beschichtung (26) aufgebracht wird.
